# EUROPÄISCHE PATENTSCHRIFT

(11) **EP 0 745 287 B1**
(45) Veröffentlichungstag und Bekanntmachung des Hinweises auf die Patenterteilung: **06.05.1998**
(21) Anmeldenummer: 94906882.9
(22) Anmeldetag: 18.02.1994
(51) Int. Cl.: H03K 17/95, H05K 7/14

(54) **NÄHERUNGSSCHALTER UND MONTAGE EINES NÄHERUNGSSCHALTERS**
PROXIMITY SWITCH AND ASSEMBLAGE THEREOF
DETECTEUR DE PROXIMITE ET MONTAGE D'UN DETECTEUR DE PROXIMITE

(43) Veröffentlichungstag der Anmeldung: 04.12.1996
(73) Patentinhaber: SIEMENS AKTIENGESELLSCHAFT, 80333 München (DE)
(72) Erfinder: SCHATZ, Wolfgang, D-92224 Amberg (DE)
(86) Internationale Anmeldenummer: DE9400172
(87) Internationale Veröffentlichungsnummer: WO9522854

(56) Entgegenhaltungen:
- DE-A- 2 819 782
- US-A- 4 090 091
- US-A- 4 528 616
- US-A- 4 654 471
- IBM TECHNICAL DISCLOSURE BULLETIN., Bd.33, Nr.6A, Oktober 1990, NEW YORK US Seiten 192 - 193, XP107681 'CONTENT SELF-CAPTURING/LOCKING ENCLOSURE'

## Beschreibung

Die Erfindung bezieht sich auf einen Näherungsschalter mit einer Schaltungsplatine und mit weiteren Geräteteilen, wobei die Schaltungsplatine einerseits durch Positionierungsmittel und andererseits durch Gießmasse in einem Hohlraum eines Gehäuseteils des Näherungsschalters gehalten ist.

Weiterhin bezieht sich die Erfindung auf ein Verfahren zur Montage eines Näherungsschalters mit einer Schaltungsplatine und mit weiteren Geräteteilen.

Ein gattungsgemäßer Näherungsschalter ist aus der US-A-4 090 091 bekannt. Bei diesem ist die Gehäuseunterseite mit einer den Abmessungen der Schaltungsplatine entsprechenden Aussparung versehen, um die Schaltungsplatine in den Innenraum des Gehäuses einzubringen. Die Aussparung wird zur Abdichtung des Gehäuses mit Gießmasse vergossen, die somit auch die Schaltungsplatine hält.

Der Erfindung liegt die Aufgabe zugrunde, einen Näherungsschalter der obengenannten Art zu schaffen, der eine Verringerung des Verdrahtungs- und Montageaufwands mit sich bringt.

Gemäß einer weiteren Aufgabe der Erfindung soll ein Verfahren zur Montage eines Näherungsschalters mit einer Schaltungsplatine und mit weiteren Geräteteilen bereitgestellt werden, durch das ebenfalls der Montage- und Verdrahtungsaufwand reduziert wird.

Die zuerst genannte Aufgabe wird dadurch gelöst, daß die Schaltungsplatine als Flachbaugruppe ausgebildet ist, daß die Positionierungsmittel zugleich als Führungsmittel zur geführten Aufnahme der Flachbaugruppe in dem Gehäuseteil ausgeführt sind, und daß die Schaltungsplatine mit Anschlußstiften versehen ist, welche mit ihrem einen Ende mit der elektrischen Schaltung auf der Flachbaugruppe verlötet sind und mit ihrem anderen Ende aus der Gießmasse herausragen.

Dieser Aufbau gewährleistet, daß die Anschlußstifte stets an gleicher Stelle in dem Gehäuseteil stehen. Der Aufbau ermöglicht eine Vormontage der Anschlußstifte. Mittels eines Steckerteils kann auf einfache Weise nach Verguß des Hohlraumes der Anschluß der Netzspannung und des Schaltausgangs erfolgen. Hierbei kann auf ein getrenntes Gehäuseteil, z.B. einen Einsatz zur Halterung wie bisher üblich, verzichtet werden.

Vorteilhafte Weiterbildungen der Erfindung ergeben sich aus den Unteransprüchen.

Eine besonders einfache Ausführungsform, die die Einführung und Positionierung der Flachbaugruppe im Hohlraum des Gehäuseteils ermöglicht, ist gegeben, wenn die Positionierungsmittel in Form von Ausnehmungen und daran angepaßten in diese greifenden Rippen bestehen, wobei die Flachbaugruppe mit den Ausnehmungen und das Gehäuseteil mit den entsprechenden Rippen versehen ist oder umgekehrt.

Die lagegenaue Halterung der Anschlußstifte auf der Flachbaugruppe wird erreicht, wenn die Anschlußstifte in zu den Positionierungsmitteln an der Flachbaugruppe definiert gelegenen Bohrungen in der Flachbaugruppe stecken und ihre definierte lagemäßige Ausrichtung durch eine Lötverbindung mit der Flachbaugruppe fixiert ist.

Weisen die Anschlußstifte einen im Durchmesser größer gehaltenen Bereich auf, der stufig zum Durchmesser des Bereichs für die Anschlußkontaktierung abgesetzt ist, so wird hierdurch im Verguß des Gehäuseteils eine mechanische Entkopplung gegen schädliche Biege-/Zugkräfte bewirkt, die auf die Lötverbindung in der Flachbaugruppe einwirken könnten.

Es ist weiterhin vorteilhaft, wenn auf der Flachbaugruppe eine Stiftleiste mit Stiften integriert ist, deren Enden aus der Gießmasse herausgeführt sind und die zur Programmierung des Ausgangs von Schließer- auf Öffnerfunktion bzw. umgekehrt mit einem entsprechenden Kurzschlußstecker versehen sind. Dies ermöglicht, die Schaltungsart jederzeit durch Einsatz des entsprechenden Kurzschlußsteckers zu ändern.

Eine besonders günstige Ausgestaltung der Erfindung besteht auch, wenn eine Leuchtdiode in einer Ausnehmung in einer außenseitigen Wand des Gehäuseteils aufgenommen ist, wobei ein Durchgang von der Ausnehmung zum Hohlraum des Gehäuseteils besteht und wenn die Ausnehmung eine die Leuchtdiode dichtend umfassende angespritzte Dichtlippe aufweist, die das Auslaufen der Gießmasse beim Verguß des Hohlraums des Gehäuseteils bei eingebauter Leuchtdiode verhindert. Es ist weiterhin vorteilhaft, wenn zur elektrischen Verbindung der Flachbaugruppe mit einem außerhalb des Gehäuseteils liegenden Sensor eine Sensorleitung durch einen Schlitz im Gehäuseteil geführt ist und eine Klemme im Durchführungsbereich vorhanden ist, die die Sensorleitung als Zugentlastung gegen zerstörende Zugkräfte in dem Gehäuseteil festklemmt und zugleich den Durchführungsbereich der Sensorleitung durch das Gehäuseteil nach außen hin gegen Auslaufen der Gießmasse beim Verguß abdichtet.

Ein besonders einfacher Anschluß ist gegeben, wenn die Sensorleitung direkt mit für die auf der Flachbaugruppe vorgesehenen Anschlußflächen elektrisch verbunden ist.

Ist auf der Flachbaugruppe ein Abgleichwiderstand integriert, von dem ein Teil mit der abgleichbaren Widerstandsschicht aus der Gießmasse des vergossenen Gehäuseteils herausragt, so ist noch nach dem Verguß der Abgleich möglich.

Vorteilhafterweise wird der aus der Gießmasse herausragende Teil mit der Widerstandsschicht auf die Gießharzoberfläche umgebogen und mit einem Tropfen Gießharz abgedeckt. Hiermit wird auf einfache Weise auch die Widerstandsschicht vor schädlichen Umwelteinflüssen geschützt.

Sind die Flachbaugruppe, die Sensorleitung, die Stiftleiste und der Abgleichwiderstand vollständig mit Gießmasse bedeckt, so wird eine geschlossene Kapselung aller wesentlichen Geräteteile zum Schutz gegen Umwelteinflüsse erreicht.

Zur Lösung der weiteren Aufgabe wird das zugrunde gelegte obengenannte Verfahren derart ausgeführt, daß nach einer Vormontage und Verlötung von Anschlußstiften auf einer als Flachbaugruppe ausgeführten Schaltungsplatine diese über Positionierungsmittel, die an der Flachbaugruppe und an einem Gehäuseteil mit einem Hohlraum vorgesehen und zugleich als Führungsmittel ausgeführt sind, in den Hohlraum definiert eingeführt und positioniert wird und daß nach Verbinden von Geräteteilen mit der Flachbaugruppe in einem weiteren Schritt die Flachbaugruppe durch Verguß des Hohlraums in Gießmasse eingebettet wird, wobei die Anschlußstifte auf der Flachbaugruppe gehalten sind und die abstehenden Enden der Anschlußstifte nach dem Verguß aus der Gießmasse herausragen.

Vorteilhafterweise werden die Anschlußstifte bei der Vormontage und Verlötung in zu den Positionierungsmitteln der Flachbaugruppe definiert gelegenen Bohrungen der Flachbaugruppe gesteckt, dann lagemäßig definiert ausgerichtet und anschließend mit der Flachbaugruppe verlötet.

Das Verfahren zur Montage eines Näherungsschalters wird weiterhin dadurch vereinfacht, daß nach Einführung und Positionierung der Flachbaugruppe in den Hohlraum vor dem Verguß lediglich als Geräteteile eine Sensorleitung auf Anschlußflächen der Flachbaugruppe und Anschlußleitungen einer Leuchtdiode auf weiteren Anschlußflächen der Flachbaugruppe verlötet werden.

Als besonders günstig hat sich erwiesen, wenn nach Verguß des Hohlraums aus der Gießmasse herausragende Enden von Stiften einer auf der Flachbaugruppe integrierten Stiftleiste zur Programmierung des Ausgangs von Schließer- auf Öffnerfunktion bzw. umgekehrt mit einem entsprechenden Kurzschlußstecker versehen werden.

Es ist weiterhin vorteilhaft, wenn auf der Flachbaugruppe ein Abgleichwiderstand integriert ist, von dem ein Teil mit der abgleichbaren Widerstandsschicht nach Verguß des Hohlraums aus der Gießmasse herausragt und wenn erst nach Verguß der Widerstandsabgleich erfolgt.

Zum Schutz der Widerstandsschicht ist es zweckmäßig, wenn nach dem Widerstandsabgleich der herausragende Teil mit der Widerstandsschicht auf der Gießharzoberfläche der Gießmasse umgebogen wird und anschließend mit einem Tropfen Gießharz abgedeckt wird.

Im folgenden wird eine Ausführungsform der Erfindung anhand einer Zeichnung näher erläutert. Es zeigen:
- FIG 1: Ein Gehäuseoberteil eines Näherungsschalters mit einer Flachbaugruppe in Draufsicht,
- FIG 2: das Gehäuseoberteil nach FIG 1 in einer seitlichen Schnittansicht,

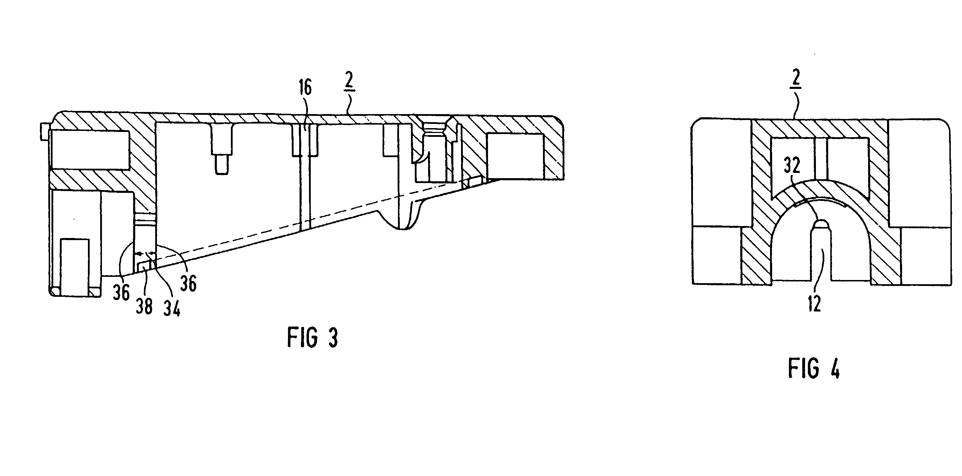

- FIG 3: das Gehäuseoberteil nach FIG 1 in einer weiteren Schnittansicht,
- FIG 4: eine Schnittansicht des Gehäuseoberteils mit Darstellung der Gehäusewand, durch die die Sensorleitung geführt wird,

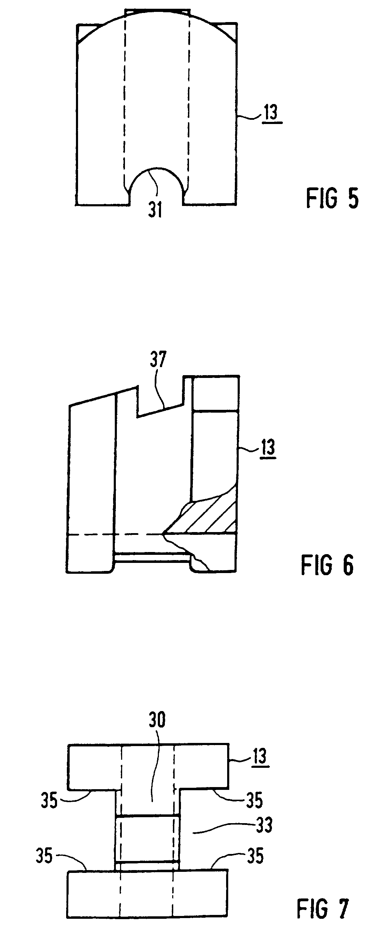

- FIG 5,6,7: eine Klemme zur Abdichtung einer Durchführung einer Sensorleitung durch das Gehäuseoberteil zu einem Sensor in verschiednen Ansichten.

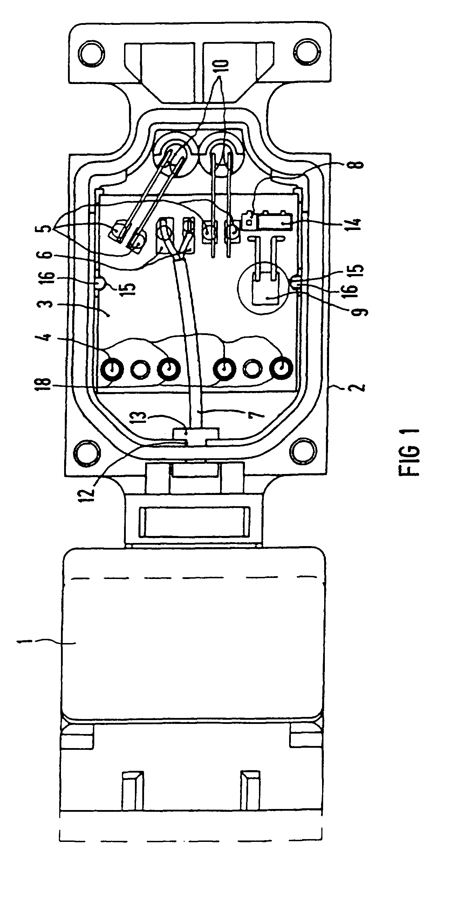

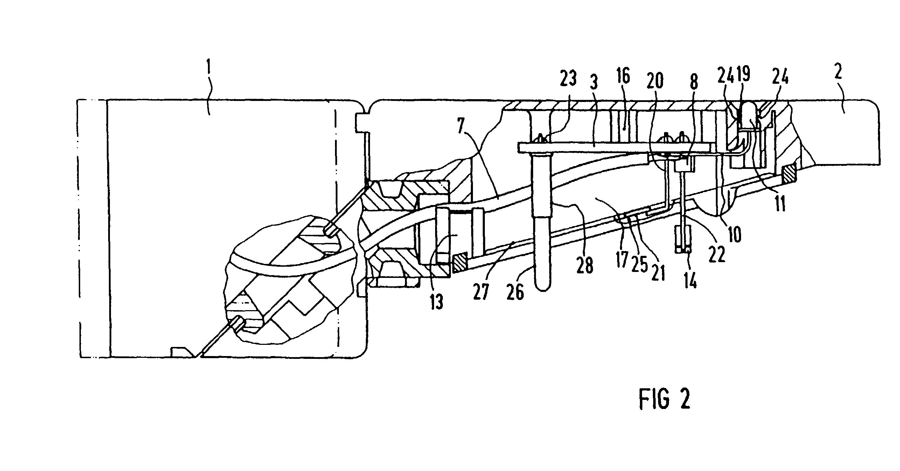

Gemäß FIG 1, 2 ist ein Gehäuseoberteil, das einen Hohlraum mit einer Aufnahmeöffnung besitzt und Teil eines, z.B. kubisch gestalteten Näherungsschalters ist, mit einem drehbar angekoppelten Sensor 1 verbunden. Ein Blick in die Aufnahmeöffnung zeigt eine als Flachbaugruppe 3 ausgeführte Schaltungsplatine mit nahezu quadratischen Abmessungen, auf der senkrecht aus der Zeichnungsebene nach vorn herausragende Anschlußstifte 4, Anschlußflächen 5 für eine optische Anzeige, Anschlußflächen 6 für eine geschirmte Sensorleitung 7, eine dreipolige Stiftleiste 8 und ein Abgleichwiderstand 9 integriert sind.

Mit den Anschlußflächen 5 sind rechtwinklig abgewinkelte Anschlußbeine 10 von zwei Leuchdioden 11 zur optischen Anzeige verlötet. Die an den Anschlußflächen 6 angelötete Sensorleitung 7 ist durch einen Schlitz 12 im Gehäuseoberteil 2 zu dem Sensor 1 geführt, wobei im Durchführungsbereich die Sensorleitung 7 mittels einer Klemme 13 festgelegt ist. Die dreipolige Stiftleiste 8 ist mit einem Kurzschlußstecker 14 versehen.

Die Flachbaugruppe 3 weist an ihren Seiten halbrunde Ausnehmungen 15 auf, in die senkrecht zur Zeichnungsebene sich längs erstreckende, an den Innenwänden des Gehäuseoberteils 2 angeformte Rippen 16 eingreifen. Die Ausnehmungen 15 dienen in Verbindung mit den Rippen 16 nicht nur als Führungsmittel bei der Einführung der Flachbaugruppe 3 in den Hohlraum des Gehäuseoberteils 2 sondern auch als Positionierungsmittel, durch die die Flachbaugruppe 3 unverrückbar in einer festen Position in der Zeichnungsebene gemäß FIG 1 gehalten wird. Durch diese Maßnahme in Verbindung mit einem Verguß des Hohlraums mit Gießmasse 17 lassen sich wesentliche Vereinfachungen bei der Verdrahtung und Montage des Näherungsschalters erreichen, wie im folgenden näher erläutert wird.

Die Flachbaugruppe 3 ist eine SMD-bestückte (Surface Mounted Device) Leiterplatte mit stets gleichen Abmessungen und gleichem Aufbau bei der Fertigung von Näherungsschaltern, mit der durch eine variable Bestückung verschiedene Schaltungsarten realisiert werden können. Stets gleich ist dabei die Anordnung und Lage bestimmter Geräteteile nach FIG 1 und 2 im Näherungsschalter wie die elektrischen Anschlußstifte 4, die Stiftleiste 8, der Abgleichwiderstand 9 sowie die elektrischen Anschlußflächen 5,6 für die optische Anzeige und die Sensorleitung 7. Es handelt sich hierbei um Geräteteile, die entweder der weiteren elektrischen Verbindung dienen oder bei der Inbetriebnahme, z.B. zum Abgleich oder bei der Festlegung der Schaltungsart leicht zugänglich sein müssen oder wie die optische Anzeige an stets gleicher Stelle im Gehäuseoberteil aufgenommen und befestigt sind, so daß selbst unter den unterschiedlichen Ausführungsformen von Näherungsschaltern eine den Montage-, Fertigungs- und Kostenaufwand verringernde Vereinheitlichung besteht.

Vor Einführung und Positionierung der SMD-bestückten Flachbaugruppe 3 im Hohlraum des Gehäuseoberteils 2 sind auf derselben die Anschlußstifte 4, der Abgleichwiderstand 9 und die dreipolige Stiftleiste 8 vormontiert. Die aus der Zeichnungsebene in FIG 1 senkrecht nach vorn herausragenden Anschlußstifte 4 stecken zur lagegenauen Halterung in gegenüber den Ausnehmungen 15 definiert positionierten Bohrungen 18. Mittels eines hier nicht dargestellten Adapters werden die Anschlußstifte 4 auf ein einheitliches eng toleriertes Maß ausgerichtet und auf der in FIG 1 nicht sichtbaren Rückseite der Flachbaugruppe 3 mit der elektrischen Schaltung durch eine Lötverbindung 23 kontaktiert, die auch die lagemäßige Ausrichtung der Anschlußstifte 4 fixiert.

Nach Einführung und Positionierung der solcher Art vorgefertigten Flachbaugruppe 3 wird die Sensorleitung 7 auf den hierfür vorgesehenen Anschlußflächen 6 aufgelötet und durch den Schlitz 12 im Gehäuseoberteil 2 geführt, wobei die im Schlitz 12 steckende Klemme 13 die Sensorleitung 7 als Zugentlastung gegen zerstörerische Zugkräfte festklemmt.

Die Klemme 13 sitzt mit ihrem Steg 30 in der schlitzförmigen Aussparung 12 des Gehäuseoberteils 2 derart, daß eine halbrunde Ausnehmung 31 in der Klemme 13 mit einer halbrunden Ausnehmung 32 im Gehäuseoberteil 2 die Sensorleitung 7, deren Außendurchmeser größer ist als der der halbrunden Ausnehmungen 31,32, einklemmt. Dadurch wird eine Abdichtung und gleichzeitig eine Zugentlastung auf die Sensorleitung 7 erreicht. Zusätzlich sind die Zwischenräume 33 der Klemme 13 zur Wanddicke 34 des Gehäuseoberteils 2 so angepaßt, daß sich beim Aufstecken die Klemme 13 aufgrund der Überschneidung fortsetzt und damit die Flächen 35 an der Klemme 13 zu den Flächen 36 der Gehäusewand abdichten.

Das Eindrückmaß der Klemme 13 ins Gehäuseoberteil 2 ergibt sich dadurch, daß die Klemme 13 mit ihrer Fläche 37 bündig mit einer Nut 38 des Gehäuseoberteils 2 eingedrückt wird. Dabei bildet sich bei korrekter Montage aus den jeweils halbrunden Ausnehmungen 31 und 32 eine runde Durchführung für die Sensorleitung 7 in das Gehäuseoberteil 2. Dadurch wird die Sensorleitung 7 leicht zusammengedrückt und so geklemmt.

Außerdem werden die Anschlußbeine 10 von den beiden Leuchtdioden 11, die in außenseitigen Gehäusebohrungen 19 der in FIG 1 hinten liegenden Wand des Gehäuseoberteils 2 stecken, rechtwinklig auf die Flachbaugruppe 3 umgebogen und mit den zugehörigen Anschlußflächen 5 verlötet.

Der auf der Flachbaugruppe 3 integrierte Abgleichwiderstand 9 ragt mit seinen Anschlußleitungen 20 und seiner abgleichbaren Widerstandsschicht 21 ebenso wie die Anschlußstifte 4 und die Stifte 22 der Stiftleiste 8 senkrecht aus der Zeichnungsebene in FIG 1 heraus. In diesem Zustand wird der Hohlraum wie aus FIG 2 ersichtlich mit Gießmasse 17 soweit vergossen, daß die Enden der Anschlußstifte 4, der Anschlußleitungen 20 mit der Widerstandsschicht 21 und die Stifte 22 der Stiftleiste 8 frei zugänglich sind. So kann nach Aushärtung des hier beispielsweise offenen Vergusses kurz vor der Inbetriebnahme des Näherungsschalters der Abgleich des Widerstands 9 vorgenommen werden und durch Aufsetzen eines entsprechenden Kurzschlußsteckers 14 auf den Stiften 22 der Stiftleiste 8 der Ausgang des Näherungsschalters in gewünschter Weise von Schließerauf Öffnerfunktion und umgekehrt programmiert werden. Der Verguß 17 wird als offen bezeichnet, wenn die Gießharzoberfläche 21 nach Aushärten offen zugänglich ist und nicht von einem getrennten Gehäuseteil wie bisher abgedeckt ist. Dadurch kann während des Gießvorganges eventuell eingeschlossene Luft besser entweichen.

Nach Abgleich des Abgleichwiderstands 9 wird der vorstehende Teil der Anschlußleitung 20 mit der Widerstandsschicht 21 auf die ausgehärtete Gießharzoberfläche 27 umgebogen und durch einen Tropfen Gießharz 25 gegen schädliche Umwelteinflüsse abgedeckt und geschützt. Somit sind nach Verguß alle Gehäuseteile, d.h. die Flachbaugruppe 3, die Sensorleitung 7 und andere mit Gießemasse 17 bedeckt, um mögliche schädliche Umwelteinflüsse fern zu halten.

Die Anschlußstifte 4 können wie bei der vorliegenden Ausführungsform einen im Durchmesser größer gehaltenen Bereich 28 aufweisen, der stufig zum Durchmesser des Bereiches für die Anschlußkontaktierung 26 abgesetzt ist. Hierdurch wird im Verguß des Gehäuseoberteils 2 eine mechanische Entkopplung gegen schädliche Biege-/Zugkräfte bewirkt, die auf die Lötverbindung 23 zwischen den Anschlußstiften 4 und der Flachbaugruppe 3 einwirken könnten.

Die stets an derselben Stelle liegenden Enden der Anschlußstifte 4 zum Anschluß der Netzspannung und des Schaltausgangs können zum Beispiel an ein Steckerteil in einem Gehäuseunterteil auf einfache Weise angekoppelt werden.

Der Schlitz 12 zur Durchführung der Sensorleitung 7 und die Verbindung zu den mit den Leuchtdioden 11 versehenen Gehäusebohrungen 19 vom oben genannten Hohlraum nach außen stellen zwei Durchführungsbereiche dar, die beim Verguß mit Gießmasse 17 einer Abdichtung bedürfen. Im Durchführungsbereich für die Sensorleitung 7 wird diese Funktion durch die außerdem für Zugentlastung der Sensorleitung 7 sorgende Klemme 13 übernommen. Die Gehäusebohrungen 19 für die Leuchtdioden 11 sind nach FIG 2 mit angeformten Dichtlippen 24 versehen, die am äußeren Umfang der Leuchtdioden 11 soweit dichtend anliegen, das ein Austritt der Gießmasse 17 beim Verguß verhindert wird. Die Leuchtdioden 11 werden in dem Bereich, der dem Innenraum von den Dichtlippen 24 her zugwandt ist, von der Gießmasse 17 eingeschlossen und auf diese Weise gehalten. Zusätzliche Gummidichtungen, wie sie bei bisherigen Näherungsschaltern üblich waren, entfallen somit.

## Patentansprüche

1. Näherungsschalter mit einer Schaltungsplatine (3) und mit weiteren Geräteteilen, wobei die Schaltungsplatine einerseits durch Positionierungsmittel (15,16) und anderseits durch Gießmasse (17) in einem Hohlraum eines Gehäuseteils (2) des Näherungsschalters gehalten ist, **dadurch gekennzeichnet,** daß die Schaltungsplatine als Flachbaugruppe (3) ausgebildet ist, daß die Positionierungsmittel (15,16) zugleich als Führungsmittel zur geführten Aufnahme der Flachbaugruppe (3) in dem Gehäuseteil (2) ausgeführt sind, und daß die Schaltungsplatine (3) mit Anschlußstiften (4) versehen ist, welche mit ihrem einen Ende mit der elektrischen Schaltung auf der Flachbaugruppe (3) verlötet sind und mit ihrem anderen Ende aus der Gießmasse (17) herausragen.

2. Näherungsschalter nach Anspruch 1, **dadurch gekennzeichnet,** daß die Positionierungsmittel in Form von Ausnehmungen (15) und daran angepaßten in diese greifenden Rippen (16) bestehen, wobei die Flachbaugruppe (3) mit den Ausnehmungen (15) und das Gehäuseteil (2) mit den entsprechenden Rippen (16) versehen ist oder umgekehrt.

3. Näherungsschalter nach Anspruch 1 oder 2, **dadurch gekennzeichnet,** daß die Anschlußstifte (4) in zu den Positionierungsmitteln (15 oder 16) an der Flachbaugruppe (3) definiert gelegenen Bohrungen (18) in der Flachbaugruppe (3) stecken und ihre definierte lagemäßige Ausrichtung durch eine Lötverbindung (23) mit der Flachbaugruppe (3) fixiert ist.

4. Näherungsschalter nach einem der vorangehenden Ansprüche, **dadurch gekennzeichnet,** daß die Anschlußstifte (4) einen im Durchmesser größer gehaltenen Bereich (28) aufweisen, der stufig zum Durchmesser eines Bereichs (26) für die Anschlußkontaktierung abgesetzt ist.

5. Näherungsschalter nach einem der vorangehenden Ansprüche, **dadurch gekennzeichnet,** daß auf der Flachbaugruppe (3) eine Stiftleiste (8) mit Stiften (22) integriert ist, deren Enden aus der Gießmasse (17) herausgeführt sind und die zur Programmierung des Ausgangs von Schließer- auf Öffnerfunktion bzw. umgekehrt mit einem entsprechenden Kurzschlußstecker (14) versehen sind.

6. Näherungsschalter nach einem der vorangehenden Ansprüche, **dadurch gekennzeichnet,** daß eine Leuchtdiode (11) in einer Ausnehmung (19) in einer außenseitigen Wand des Gehäuseteils (2) aufgenommen ist, wobei ein Durchgang von der Ausnehmung (19) zum Hohlraum des Gehäuseteils (2) besteht und daß die Ausnehmung (19) eine die Leuchtdiode (11) dichtend umfassende, angespritzte Dichtlippe (24) aufweist, die das Auslaufen der Gießmasse (17) beim Verguß des Hohlraums des Gehäuseteils (2) bei eingebauter Leuchtdiode (11) verhindert.

7. Näherungsschalter nach einem der vorangehenden Ansprüche, **dadurch gekennzeichnet,** daß zur elektrischen Verbindung der Flachbaugruppe (3) mit einem außerhalb des Gehäuseteils (2) liegenden Sensor (1) eine Sensorleitung (7) durch einen Schlitz (12) im Gehäuseteil (2) geführt ist und eine Klemme (13) im Durchführungsbereich vorhanden ist, die die Sensorleitung (7) als Zugentlastung gegen zerstörende Zugkräfte in dem Gehäuseteil (2) festklemmt und zugleich den Durchführungsbereich der Sensorleitung (7) durch das Gehäuseteil (2) nach außen hin gegen Auslaufen der Gießmasse (17) beim Verguß abdichtet.

8. Näherungsschalter nach Anspruch 7, **dadurch gekennzeichnet,** daß die Sensorleitung (7) direkt mit für die auf der Flachbaugruppe (3) vorgesehenen Anschlußflächen (6) elektrisch verbunden ist.

9. Näherungsschalter nach einem der vorangehenden Ansprüche, **dadurch gekennzeichnet,** daß auf der Flachbaugruppe (3) ein Abgleichwiderstand (9) integriert ist, von dem ein Teil mit der abgleichbaren Widerstandsschicht (21) aus der Gießmasse (17) des vergossenen Gehäuseteils (2) herausragt.

10. Näherungsschalter nach Anspruch 9, **dadurch gekennzeichnet,** daß der aus der Gießmasse (17) herausragende Teil mit Widerstandsschicht (21) auf die Gießharzoberfläche (27) umgebogen und mit einem Tropfen Gießharz (25) abgedeckt ist.

11. Näherungsschalter nach einem der Ansprüche 7 bis 10, **dadurch gekennzeichnet,** daß die Flachbaugruppe (3) die Sensorleitung (7), die Stiftleiste (8) und der Abgleichwiderstand (9) vollständig mit Gießmasse (17) bedeckt sind.

12. Verfahren zur Montage eines Näherungsschalters mit einer Schaltungsplatine und mit weiteren Geräteteilen,
**dadurch gekennzeichnet,** daß nach Vormontage und Verlötung von Anschlußstiften (4) auf einer als Flachbaugruppe (3) ausgeführten Schaltungsplatine diese über Positionierungsmittel (15,16), die an der Flachbaugruppe (3) und an einem Gehäuseteil (2) mit einem Hohlraum vorgesehen und zugleich als Führungsmittel ausgeführt sind, in den Hohlraum definiert eingeführt und positioniert wird, und daß nach Verbinden von Geräteteilen (11,20,7) mit der Flachbaugruppe (3) in einem weiteren Schritt die Flachbaugruppe (3) durch Verguß des Hohlraums in Gießmasse (17) eingebettet wird, wobei die Anschlußstifte (4) auf der Flachbaugruppe (3) gehalten sind und die abstehenden Enden der Anschlußstifte (4) nach dem Verguß aus der Gießmasse (17) herausragen.

13. Verfahren nach Anspruch 12, **dadurch gekennzeichnet,** daß die Anschlußstifte (4) bei der Vormontage und Verlötung in zu den Positionierungsmitteln (15 oder 16) der Flachbaugruppe (3) definiert gelegenen Bohrungen (18) in der Flachbaugruppe (3) gesteckt werden, dann lagemäßig definiert ausgerichtet werden und anschließend mit der Flachbaugruppe (3) verlötet werden.

14. Verfahren nach Anspruch 12 oder 13, **dadurch gekennzeichnet,** daß nach Einführung und Positionierung der Flachbaugruppe (3) in dem Hohlraum vor dem Verguß lediglich als Geräteteile eine Sensorleitung (7) auf Anschlußflächen (6) der Flachbaugruppe (3) und Anschlußleitungen (20) einer Leuchtdiode (11) auf weiteren Anschlußflächen (5) der Flachbaugruppe (3) verlötet werden.

15. Verfahren nach einem der Ansprüche 12 bis 14,
**dadurch gekennzeichnet,** daß nach Verguß des Hohlraums aus der Gießmasse (17) herausragende Enden von Stiften (22) einer auf der Flachbaugruppe (3) integrierten Stiftleiste (8) zur Programmierung des Ausgangs von Schließer- auf Öffnerfunktion bzw. umgekehrt mit einem entsprechenden Kurzschlußstecker (14) versehen werden.

16. Verfahren nach einem der vorangehenden Ansprüche 12 bis 15, **dadurch gekennzeichnet,** daß auf der Flachbaugruppe (3) ein Abgleichwiderstand (9) integriert ist, von dem ein Teil mit der abgleichbaren Widerstandsschicht (21) nach Verguß des Hohlraums aus der Gießmasse (17) herausragt und daß erst nach Verguß der Widerstandsabgleich erfolgt.

17. Verfahren nach Anspruch 16, **dadurch gekennzeichnet,** daß nach dem Widerstandsabgleich der herausragende Teil mit der Widerstandsschicht (21) auf die Gießharzoberfläche (27) der Gießmasse (17) umgebogen wird und anschließend mit einem Tropfen Gießharz (25) abgedeckt wird.

## Claims

1. Proximity switch having a printed circuit board (3) and having other device components, the printed circuit board being retained, on the one hand by positioning means (15, 16) and on the other hand by potting material (17), in a cavity of a housing part (2) of the proximity switch, characterised in that the printed circuit board is designed as a card module (3), in that the positioning means (15, 16) are constructed to serve at the same time as guide means for guided reception of the card module (3) in the housing part (2) and in that the printed circuit board (3) is provided with connecting pins (4) which are soldered with their one end to the electrical circuit on the card module (3) and which project with their other end from the potting material (17).

2. Proximity switch according to Claim 1, characterised in that the positioning means take the form of recesses (15) and ribs (16) that are adapted to said recesses and engage therein, the card module (3) being provided with the recesses (15) and the housing part (2) being provided with the corresponding ribs (16) or vice versa.

3. Proximity switch according to Claim 1 or 2,
characterised in that the connecting pins (4) are set in bores (18) in the card module (3) that are located in defined manner in relation to the positioning means (15 or 16) on the card module (3) and their defined locational alignment is fixed by means of a soldered connection (23) to the card module (3).

4. Proximity switch according to one of the preceding claims, characterised in that the connecting pins (4) comprise a region (28) that is maintained larger in diameter and is offset in stepped manner in relation to the diameter of a region (26) for the connecting contact.

5. Proximity switch according to one of the preceding claims, characterised in that there is integrated on the card module (3) a pin strip (8) having pins (22), the ends of which are led out of the potting material (17) and which are provided with an appropriate short-circuiting plug (14) with a view to programming the output from make-contact function to break-contact function or vice versa.

6. Proximity switch according to one of the preceding claims, characterised in that a light-emitting diode (11) is received in a recess (19) in an exterior wall of the housing part (2), there being a passage from the recess (19) to the cavity of the housing part (2), and in that the recess (19) comprises an integrally cast sealing lip (24) enclosing the light-emitting diode (11) in sealing manner, said sealing lip preventing the potting material (17) from spilling out in the course of potting the cavity of the housing part (2) in the case where a light-emitting diode (11) is installed.

7. Proximity switch according to one of the preceding claims, characterised in that, with a view to electrical connection of the card module (3) to a sensor (1) located outside the housing part (2), a sensor lead (7) is guided through a slot (12) in the housing part (2) and a clip (13) is present in the bushing region which firmly clamps the sensor lead (7) in the housing part (2) as a strain relief against destructive tensile forces and at the same time seals the bushing region of the sensor lead (7) through the housing part (2) towards the outside to prevent the potting material (17) from spilling out in the course of potting.

8. Proximity switch according to Claim 7, characterised in that the sensor lead (7) is directly connected electrically to connecting pads (6) that are provided on the card module (3).

9. Proximity switch according to one of the preceding claims, characterised in that there is integrated on the card module (3) a balancing resistor (9) from which a part with the balanceable resistive layer (21) projects from the potting material (17) of the potted housing part (2).

10. Proximity switch according to Claim 9,
characterised in that the part with the resistive layer (21) projecting from the potting material (17) is bent over onto the potting-resin surface (27) and covered with a drop of potting resin (25).

11. Proximity switch according to one of Claims 7 to 10, characterised in that the card module (3), the sensor lead (7), the pin strip (8) and the balancing resistor (9) are completely covered with potting material (17).

12. Process for the assembly of a proximity switch having a printed circuit board and having other device components, characterised in that, after preassembly and soldering of connecting pins (4) on a printed circuit board that is constructed as a card module (3), the latter is introduced into and positioned within the cavity in defined manner with the aid of positioning means (15, 16) which are provided on the card module (3) and on a housing part (2) having a cavity and which are constructed to serve at the same time as guide means, and in that, after connection of device components (11, 20, 7) to the card module (3), in a further step the card module (3) is embedded in potting material (17) by potting of the cavity, the connecting pins (4) being retained on the card module (3) and the protruding ends of the connecting pins (4) projecting from the potting material (17) after potting.

13. Process according to Claim 12, characterised in that in the course of preassembly and soldering the connecting pins (4) are set in bores (18) in the card module (3) that are located in defined manner in relation to the positioning means (15 or 16) of the card module (3), then they are aligned in locationally defined manner and subsequently soldered to the card module (3) .

14. Process according to Claim 12 or 13, characterised in that after introduction and positioning of the card module (3) within the cavity prior to the potting, by way of device components merely a sensor lead (7) is soldered to connecting pads (6) of the card module (3) and connecting leads (20) pertaining to a light-emitting diode (11) are soldered to additional connecting pads (5) of the card module (3).

15. Process according to one of Claims 12 to 14, characterised in that, after potting of the cavity, ends of pins (22) projecting from the potting material (17) that pertain to a pin strip (8) which is integrated on the card module (3) are provided with an appropriate short-circuiting plug (14) with a view to programming the output from make-contact function to break-contact function or vice versa.

16. Process according to one of the preceding Claims 12 to 15, characterised in that there is integrated on the card module (3) a balancing resistor (9) from which a part with the balanceable resistive layer (21) projects from the potting material (17) after potting of the cavity and in that balancing of the resistor is effected only after potting.

17. Process according to Claim 16, characterised in that after the resistor has been balanced the projecting part with the resistive layer (21) is bent over onto the potting-resin surface (27) of the potting material (17) and is subsequently covered with a drop of potting resin (25).

## Revendications

1. Détecteur de proximité, comportant une platine de commutation (3) et d'autres éléments d'appareil, la platine de commutation étant retenue dans un espace creux d'une partie (2) de boîtier du détecteur de proximité, d'une part par des moyens de positionnement (15, 16) et d'autre part par une masse de scellement (17), caractérisé par le fait que la platine de commutation est réalisée sous la forme d'un composant plat (3), que les moyens de positionnement (15, 16) sont réalisés en même temps en tant que moyens de guidage destinés à recevoir le composant plat (3) de façon guidée dans la partie (2) du boîtier, et que la platine de commutation (3) est munie de broches de raccordement (4) qui sont brasées par l'une de leurs extrémités sur le circuit électrique se trouvant sur le composant plat (3), et qui dépassent de la masse de scellement (17) par leur autre extrémité.

2. Détecteur de proximité selon la revendication 1, caractérisé par le fait que les moyens de positionnement sont réalisés sous la forme d'évidements (15) et de nervures adaptées (16) qui s'y engagent, le composant plat (3) étant en l'occurrence muni des évidements (15) et la partie (2) du boîtier des nervures (16) correspondantes, ou inversement.

3. Détecteur de proximité selon la revendication 1 ou 2, caractérisé par le fait que les broches de raccordement (4) sont insérées dans des perçages (18) du composant plat (3), qui sont situés de façon définie par rapport aux moyens de positionnement (15 ou 16) du composant plat (3), et que leur orientation en position définie est fixée sur le composant plat (3) par une liaison brasée (23).

4. Détecteur de proximité selon l'une quelconque des revendications précédentes, caractérisé par le fait que les broches de raccordement (4) comportent une zone (28) de diamètre plus grand, qui se réduit par gradins au diamètre d'une zone (26) destinée au contact de raccordement.

5. Détecteur de proximité selon l'une quelconque des revendications précédentes, caractérisé par le fait qu'il est intégré sur le composant plat (3) une réglette (8) avec des broches (22), dont les extrémités sortent de la masse de scellement (17) et qui est munie d'une fiche de court-circuitage (14) appropriée pour la programmation de la sortie de la fonction de fermeture à la fonction d'ouverture, ou inversement.

6. Détecteur de proximité selon l'une quelconque des revendications précédentes, caractérisé par le fait qu'une diode luminescente (11) est logée dans un évidement (19) d'une paroi extérieure de la partie (2) du boîtier, un passage existant entre l'évidement (19) et l'espace creux de la partie (2) du boîtier, et que l'évidement (19) comporte une lèvre d'étanchéité (24) rapportée par injection, qui enserre la diode luminescente (11) de façon étanche, et qui à l'état monté de la diode luminescente (11) empêche l'écoulement de la masse de scellement (17) lors du scellement de l'espace creux de la partie (2) du boîtier.

7. Détecteur de proximité selon l'une quelconque des revendications précédentes, caractérisé par le fait que, pour la liaison électrique du composant plat (3) à un capteur (1) situé à l'extérieur de la partie (2) du boîtier, une ligne (7) de capteur passe par une fente (12) pratiquée dans la partie (2) du boîtier, et qu'il est prévu dans la zone de passage un serre-câble (13) qui, en tant que décharge en traction contre des forces de traction destructrices, bloque la ligne (7) du capteur dans la partie (2) du boîtier, et assure simultanément l'étanchéité vers l'extérieur de la zone de passage de la ligne (7) du capteur par la partie (2) du boîtier afin d'empêcher l'écoulement de la masse de scellement (17) lors du scellement.

8. Détecteur de proximité selon la revendication 7, caractérisé par le fait que la ligne (7) du capteur est reliée électriquement directement aux surfaces de raccordement (6) prévues sur le composant plat (3).

9. Détecteur de proximité selon l'une quelconque des revendications précédentes, caractérisé par le fait qu'il est intégrée sur le composant plat (3) une résistance d'équilibrage (9), dont une partie comportant la couche de résistance (21) pouvant être équilibrée dépasse de la masse de scellement (17) de la partie (2) scellée du boîtier.

10. Détecteur de proximité selon la revendication 9, caractérisé par le fait que la partie comportant la couche de résistance (21), qui dépasse de la masse de scellement (17), est recourbée sur la surface (27) de la résine de scellement et est recouverte d'une goutte de résine de scellement (25).

11. Détecteur de proximité selon l'une quelconque des revendications 7 à 10, caractérisé par le fait que le composant plat (3), la ligne (7) du capteur, la réglette (8) à broches et la résistance d'équilibrage (9) sont entièrement recouvertes de masse de scellement (17).

12. Procédé de montage d'un détecteur de proximité comportant une platine de commutation et d'autres éléments d'appareil, caractérisé par le fait que, après le montage préalable et le brasage de broches de raccordement (4) sur une platine de commutation réalisée sous la forme d'un composant plat (3), celle-ci est insérée de façon définie et positionnée dans un espace creux par l'intermédiaire de moyens de positionnement (15, 16) réalisés simultanément en tant que moyens de guidage, qui sont prévus sur le composant plat (3) et sur une partie (2) de boîtier comportant l'espace creux, et qu'après la liaison d'éléments d'appareil (11, 20, 7) au composant plat (3) dans une phase suivante, le composant plat (3) est enrobé d'une masse de scellement (17) par le scellement de l'espace creux, les broches de raccordement (4) étant retenues sur le composant plat (3), et les extrémités qui dépassent des broches de raccordement (4) sortant de la masse de scellement (17) après le scellement.

13. Procédé selon la revendication 12, caractérisé par le fait que, lors du montage préalable et du brasage, les broches de raccordement (4) sont insérées dans des perçages (18) du composant plat (3) situés de façon définie par rapport aux moyens de positionnement (15 ou 16) du composant plat (3), et qu'elles sont ensuite orientées en position définie et brasées sur le composant plat (3).

14. Procédé selon la revendication 12 ou 13, caractérisé par le fait qu'après l'insertion et le positionnement du composant plat (3) dans l'espace creux, les seuls éléments d'appareil restant à braser avant le scellement sont une ligne (7) de capteur sur des surfaces de raccordement (6) du composant plat (3), et des lignes de raccordement (20) d'une diode luminescente (11) sur d'autres surfaces de raccordement (5) du composant plat (3).

15. Procédé selon l'une quelconque des revendications 12 à 14, caractérisé par le fait que des extrémités de broches (22) d'une réglette (8) à broches intégrée sur le composant plat (3), qui sortent de la masse de scellement (17) après le scellement de l'espace creux, sont munies d'une fiche de court-circuitage (14) appropriée pour la programmation de la sortie de la fonction de fermeture à la fonction d'ouverture, ou inversement.

16. Procédé selon l'une quelconque des revendications précédentes 12 à 15, caractérisé par le fait qu'il est intégrée sur le composant plat (3) une résistance d'équilibrage (9), dont une partie comportant la couche de résistance (21) pouvant être équilibrée dépasse de la masse de scellement (17) après le scellement de l'espace creux, et que l'équilibrage de la résistance n'est effectué qu'après le scellement.

17. Procédé selon la revendication 16, caractérisé par le fait que, après l'équilibrage de la résistance, la partie dépassant comportant la couche de résistance (21) est recourbée sur la surface (27) de la résine de scellement de la masse de scellement (17), et ensuite est recouverte d'une goutte de résine de scellement (25).
